# EUROPEAN PATENT APPLICATION

(11) **EP 1 936 662 A2**
(43) Date of publication of application: **25.06.2008**
(21) Application number: 07024751.5
(22) Date of filing: 20.12.2007
(51) Int. Cl.: H01L 21/00, G01R 31/26, H01L 21/66

(54) **System for supplying a termal agent to a testing machine for testing objects under thermally hard circumstances**

(30) Priority: 22.12.2006 JP 2006345758
(71) Applicant: Espec Corp., Kita-ku Osaka-shi Osaka 530-8550 (JP)
(72) Inventor: Nakanishi, Masataka, Osaka-shi Osaka 530-8550 (JP); Kurara, Hironobu, Osaka-shi Osaka 530-8550 (JP); Nishikawa, Teihei, Osaka-shi Osaka 530-8550 (JP)
(74) Representative: Paul, Dieter-Alfred

(57) **Abstract**

A system for supplying a thermal agent to a testing machine used to test objects such as electronic devices and mechanical components to see how they can withstand thermally hard circumstances created by the thermal agent supplied from a supplying section communicating with the testing machine, wherein heat exchange is effected between the incoming agent and the outgoing agent, so that the remaining heat content, worm or cold, is taken and utilized for later uses.

## Description

### TECHNICAL FIELD

The present invention relates to a system for supplying a thermal agent to a testing machine for testing mechanical components or electronic devices to see how they can withstand thermally hard circumstances created by using a thermal medium or agent, from which heat content, warm or cold, is taken. The thermal agent is hereinafter called "agent."

### BACKGROUND ART

Among mechanical components and electronic appliances, cellphones and personal computers have occasions where they are used under thermally hard circumstances. This requires that their mechanical and electronic component parts, such as integrated circuits, should be previously checked to see if they can function properly under the anticipated hard circumstances. For testing machines for such use, there are some proposals disclosed in Japanese Patent Laid-open Application No. 2005-45039 and No. H10-288646, which are designed to expose testing objects such as wafers, to high or low temperatures.

These known testing machines each are provided with a thermal adjuster, such as a thermostat, which has a tray, and possibly with an electric heater. A testing object, such as wafers, is placed on the tray. In addition, the testing machine has a cavity through which a warm or cold agent having a desired temperature is flown to maintain the top surface of the tray at a desired temperature; for example, when the surface of the tray is to be maintained at low temperature, an agent having a corresponding low temperature is flown through the cavity.

The thermostat maintains the tray at a desired temperature by controlling an electric heater or flowing an agent having a corresponding temperature into the cavity; for example, in order to cool the tray, a cold agent is flown into the cavity.

In recent years the industry demands a stricter testing standard, and also a larger tray for testing a greater deal of objects in a shorter time. In order to meet these demands, the agent supplying system tends to become large. Accordingly, a large thermal adjuster is required for supplying an agent to the cavity of the testing machine at a desired temperature. Therefore, the inventors devised a testing machine which is independent of the thermal adjuster.

More specifically, if a cold atmosphere is required for testing, a cold agent having a desired low temperature is produced in the agent supplying section, and supplied to the testing section through the inlet tube, so as to conduct the test in the testing section. The used agent, still warm, is discharged from the testing section through the outlet tube, and collected in the agent supplying section.

It was ascertained that the trial supplying apparatus has a large cooling capacity as compared with the conventional supplying machine, thereby securing low temperatures, so that the thermal adjuster in the agent supplying section was efficiently cooled to a desired temperature. However, the inventors recognized that the cooled agent undesirably absorbs heat from the atmosphere and becomes warm while passing through the inlet tube. This trades off the advantage of the increased cooling efficiency.

More specifically, the agent required for testing an object must have a temperature of -90° C or below, but while passing through the inlet tube, the cold agent unavoidably gains heat from the atmosphere because of the significant difference in temperature between the cold agent and the atmosphere. The inventors found that the thermal adjuster had a limited range of adjusting temperatures.

In order to compensate for the loss of energy, the cooling device must have an adequate capacity, and therefore, a large electric power must be used.

Accordingly, the present invention is to solve the problem mentioned above, and to provide an agent supplying system in which a cool agent is supplied with its low temperature to the thermal adjuster of the testing machine.

### SUMMARY OF THE INVENTION

According to a first version embodying the present invention a system for supplying a thermal agent to a testing machine, includes a testing section for conducting the tests; a thermal agent supplying section communicating with the testing section by and through an inlet flow path and an outlet flow path; a thermal adjuster accommodated in the testing section so as to produce and maintain a desired temperature therein; a cooling device operable in a cyclic system, having a first heat exchanger for adjusting the temperature of an incoming agent to the testing section through the inlet flow path; and an auxiliary inlet flow path located arranged side by side with the inlet flow path so as to effect heat exchange between a coolant flowing through the auxiliary inlet flow path and an incoming agent through the inlet flow path.

In the first version the auxiliary inlet flow path is arranged side by side with the inlet flow path so as to effect heat exchange between a coolant flowing through the auxiliary inlet flow path and an incoming agent through the inlet flow path.

According to a second version, the primary side of a first heat exchanger is used to flow a coolant, and the secondary side is used to flow an incoming agent to the thermal adjuster in the testing section, and additionally, includes a bypass extending from a primary side of the first heat exchanger, the bypass communicating with the auxiliary inlet flow path.

In the second version the bypass of the first heat exchanger is connected to an auxiliary inlet flow path, thereby ensuring that the coolant flowing through the auxiliary inlet flow path can have the same temperature as that of a coolant flowing through the first heat exchanger. Thus, the agent flowing through the inlet flow path is enabled to reach the thermal adjuster with the same temperature.

According to a third version, the first heat exchanger is connected in series to the auxiliary inlet flow path.

According to a fourth version, the outlet flow path from the thermal adjuster and the auxiliary outlet flow path arranged side by side with each other such that an incoming agent from the atmosphere or an outgoing agent from the thermal adjuster is introduced into the auxiliary outlet flow path, and then into the heat exchanger (A).

The fourth version ensures that coolness is taken from the outgoing agent from the thermal adjuster.

In addition, the fourth version allows the outgoing cool agent from the thermal adjuster to flow through the outlet flow path, so that the incoming agent flowing through the auxiliary outlet flow path is cooled. The cooled agent is additionally cooled by the first heat exchanger.

According to a fifth version, a heat-collecting heat exchanger is provided to effect heat exchange between the outgoing agent through the outlet flow path and an incoming from the atmosphere.

The heat-collecting heat exchange added in the fifth version facilitates the taking-up of coldness from the outgoing agent from the thermal adjuster, thereby enhancing the whole thermal efficiency.

According to a sixth version, the cooling device is provided with a compressor and an auxiliary second heat exchanger for taking coldness from the agent whereby heat exchange is effected between an outgoing agent from the thermal adjuster and a coolant from the compressor.

The sixth version ensures that the coolant is condensed by a cool agent through the outlet flow path. Thus, the total thermal efficiency is considerably enhanced.

According to a seventh version, each of the combination of the inlet flow path and the auxiliary inlet flow path, and the combination of the outlet flow path and the auxiliary outlet flow path has a multi-layer structure of a central tube and an outer tube covering at least part of the central tube.

According to an eighth version, one of the combination of the inlet flow path and the auxiliary inlet flow path, and the combination of the outlet flow path and the auxiliary outlet flow path has a multi-layer structure of a central tube and an outer tube covering at least part of the central tube.

The double structure of the seventh and eighth versions ensure that the inlet flow path and the auxiliary inlet flow path can overlap in a large area, thereby increasing the heat exchange efficiency.

According to a ninth version, the central tube is provided with an inserted pipe through which an agent is allowed to flow in and out, the inserted pipe being open in the depth of the central tube.

The ninth version ensures that a longer period of stay of the coolant in the inserted pipe contributes to increase heat exchange between the agent flowing through the flow path.

According to a tenth version, the central tube includes a port located near its distal end through which an agent or a coolant is entered or discharged, and the inserted pipe is inserted near the port.

According to an eleventh version, the thermal agent is a gas to stay therein, and the thermal adjuster comprises a cavity for receiving the gaseous agent.

The eleventh version ensures that the gaseous agent can be readily filled in the cavity and the inside temperature can be adjusted in a relatively wide range.

The embodiments mentioned above ensure that a cool agent can be supplied to the thermal adjuster. Therefore, the temperature can be controlled in a wide range.

### BRIEF DESCRIPTION OF THE DRAWINGS

Fig. 1 is a perspective view showing an agent supplying system according to the present invention;
Fig. 2 is a diagram showing the piping indicated in Fig. 1;
Fig. 3 is a diagram particularly showing in detail an inlet flow path in the piping shown in Fig. 2;
Fig. 4 is a sectional view throughout the inlet flow path shown in Fig. 3;
Fig. 5 is a sectional view throughout the outlet flow path in the piping shown in Fig. 1;
Fig. 6 (A) is a partly cross-sectional perspective view showing a modified inlet flow path;
Fig. 6 (B) is a partly cross-sectional perspective view showing a modified outlet flow path; and
Fig. 7 is a diagram showing a piping in another embodiment of the invention in Fig. 1.

### DESCRIPTION OF THE PREFERED EMBODIMENTS

### General:

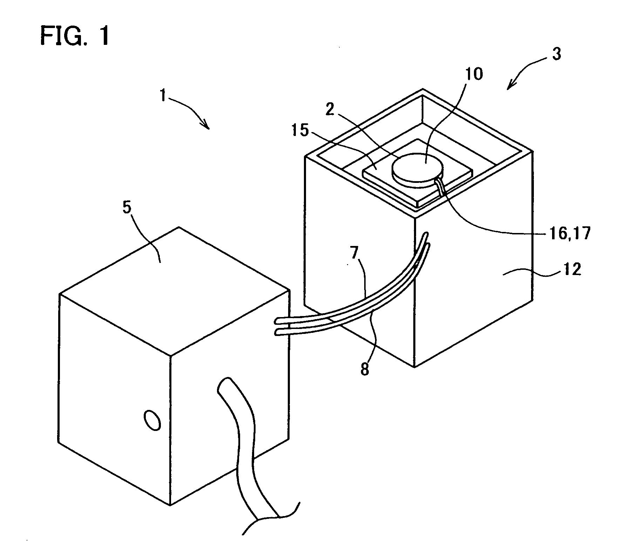

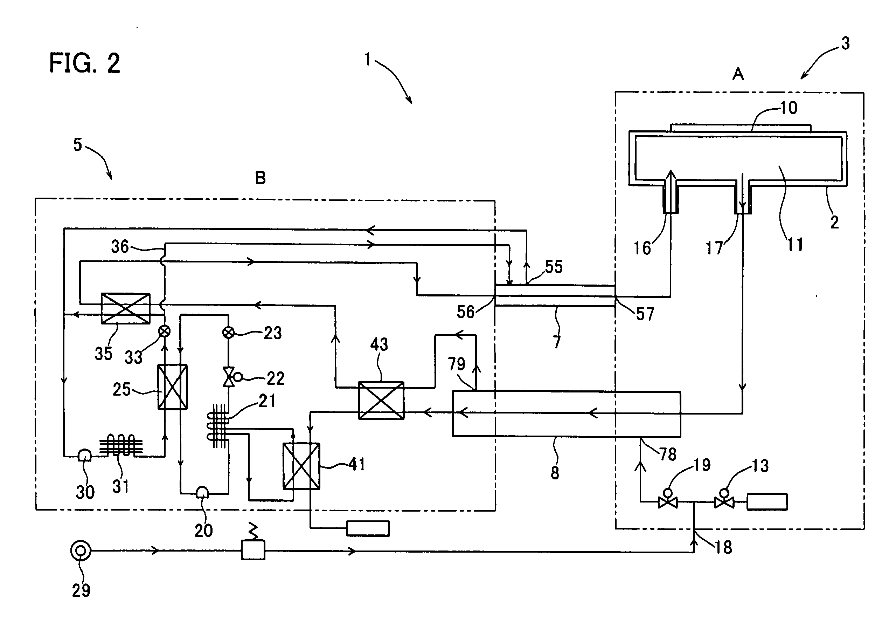

In the following description the above-mentioned first heat exchanger for adjusting the temperature of a warm agent will be referred to as "heat exchanger (A)", and likewise the second heat for taking up coldness from a coolant will be referred to as "heat exchanger (B)".
Referring to Fig. 1, the illustrated testing machine 1 includes a testing section 3 and an agent supplying section 5, wherein the agent is a substance from which heat energy, warm or cold, can be taken. The testing section 3 includes a thermal plate or tray 2. The piping shown in Fig. 2, wherein the frame (A) shows a part of the piping located in the testing section 3, and the frame (B) shows a part of it located in the agent supplying section 5. The two sections 3 and 5 are communicatively connected to each other by an inlet tube 7 and an outlet tube 8, wherein the tube can be cylindrical or rectangular in its cross-section.

The tray 2 of disc-shape can function as a chuck in its heated or cooled state, and receives a testing object placed on its top surface 10. The surface of the tray 2 is maintained at a desired temperature, warm or cold, the tray 2 having an electric heater (not shown), and a cavity 11 adapted for being filled with a cold air in circulation so as to maintain the tray 2 at a desired low temperature. In addition, the tray 2 is provided with a vacuum device (not shown) for holding a testing object on the top surface 10 under suction.

As shown in Fig. 1, the tray 2 is accommodated in a casing 12 separated from the agent supplying section 5, and placed on a table 15. The table 15 can move in the X and Y directions by means of an electric motor (not shown). The casing 12 accommodates pipes 16 and 17 through which the cavity 11 communicates with the atmosphere outside the casing 12.

The casing 12 is provided with an air-inlet 18 whose distal portion branches off into two ends, one end being connected to an inlet 78 of the outlet tube 8 through a electromagnet valve 19, and the other end being open in the atmosphere through an electromagnet valve 13.

The air-inlet 18 is connected to a source of dry air 29 (e.g. a compressor) through a pressure reducing valve (not shown), and is open into the atmosphere.

### Two Cooling Cycles

The agent supplying section 5 includes a cooling device for cooling the air introduced therein. The cooling device is operated in a cyclic cooling system; in the illustrated embodiment, two cooling cycles; a first cycle consisting of a first compressor 20, a first condenser 21, a flow rate adjuster 22, a first expanding valve 23, and a primary side of a heat exchanger (B) 25, and a second cycle consisting of a second compressor 30, a second condenser 31, a secondary side of the heat exchanger (B) 25, a second expanding valve 33, and a heat exchanger (A) 35, wherein as defined above, the heat exchanger (A) 35 is used for adjusting the temperature of a warm agent, and the heat exchanger (B) 25 is used for cooling a coolant.

The two cycles generally receive fluorocarbon or any other agent which is liable to phase change and achieve cooling cycle. More specifically, in the first cycle the agent is compressed by the first compressor 20, and condensed by the condenser 21 with the help of a fan (not shown). Then the cooled agent flows through the first expanding valve 23, and gasifies on the primary side of the heat exchanger (B) 25 to take up the heat, and returns to the first compressor 20 in the form of gas.

In the second cycle the agent is compressed by the second compressor 30, and condensed by the second condenser 31 with the help of a fan, thereby obtaining a cool agent. Then, the cool agent enters the secondary side of the heat exchanger (B) 25, and is more cooled into a liquid under the action of the first cycle. The agent flowing through the second cycle passes through the second expanding valve 33, and liquefies at the primary side of the heat exchanger (A) 35 to cause the agent to lose more heat. The vaporized agent returns to the compressor 30.

As a preferred embodiment, an auxiliary heat exchanger (B) 41 for cooling the agent and a heat exchanger 43 for collecting coldness are provided within the agent supplying section 5. The secondary flow path of the auxiliary heat exchanger (B) 41 is connected in series to the middle part of the flow path of the first condenser 21.

### The Structure and Operation of the Inlet Tube 7

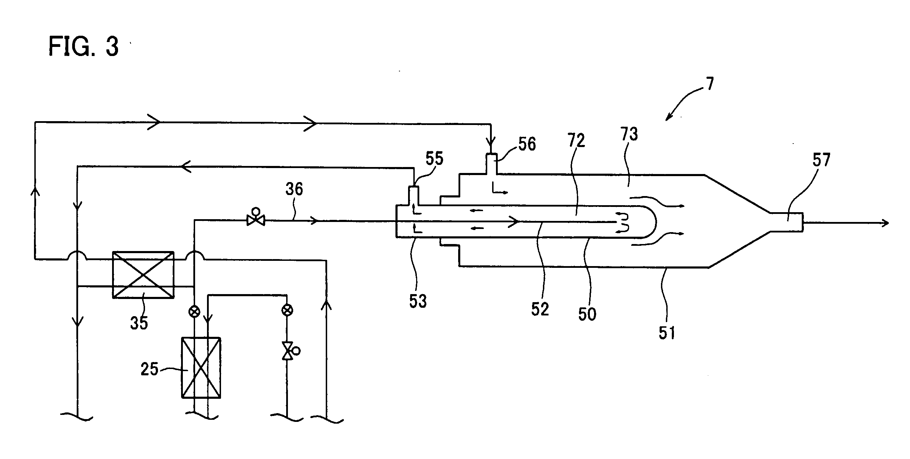

In Fig. 3, the inlet tube 7 has a triple-layer structure with a central tube 50, an outer tube 51, and an inserted pipe 52 extending inside the central tube 50.

The central tube 50 has a head portion (unnumbered) and a bottom portion 53, and its greater part is located within the outer tube 51 with the bottom portion 53 extending beyond the outer tube 51, provided with a coolant outlet 55. The outside diameter of the central tube 50 is smaller than the inside diameter of the outer tube 51 so as to produce a ring-shaped space therebetween, the space functioning as an inlet flow path 73.

The pipe 52 inserted through the bottom portion 53 of the central tube 50 is open near the head of the central tube 50. The inserted pipe 52 has a smaller outside diameter than the inside diameter of the central tube 50 so as to produce a ring-shaped space therebetween, the space functioning as an auxiliary inlet flow path 72. In this way the auxiliary inlet flow path 72 is arranged side by side with the inlet flow path 73 so as to exchange heat easily therebetween. The outer tube 51 has an air-inlet 56 at its proximal end, and an air-outlet 57 at its distal end.

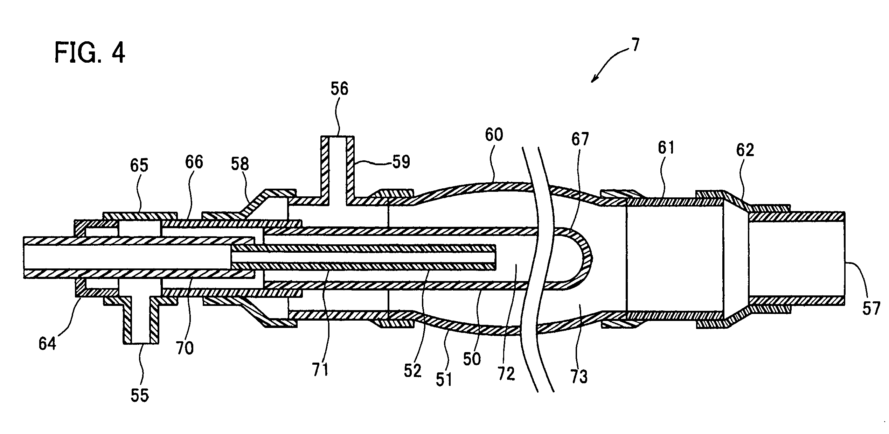

More specifically, in Fig. 4 the inlet tube 7 is made of the outer tube 51 having a first coupler 58, a T-shaped member 59, a flexible tube 60, a short pipe 61, and a second coupler 62, all of which are successively connected one to another, taking the shape of a thick central portion and opposite slim end portions, and as a whole, being flexible.

The central tube 50 consists of a short pipe 64, a T-shaped member 65, another short pipe 66, and a closed plastics tube 67 successively connected one to another. The outside diameter of the central tube 50 is smaller than the inside diameter of the outer tube 51 so as to produce a space which functions as the inlet flow path 73.

A greater part of the short pipe 66 is housed within the outer tube 51. The short pipe 66 is liquid-tightly closed against the coupler 58.

The inserted pipe 52 consists of a short pipe 70, and a resilient slender pipe 71 connected to the short pipe 70. The short pipe 70 partly overlaps with the short pipe 66 of the central tube 50, and the slender pipe 71 reaches a point near the head of the central tube 50. The inserted pipe 52 has a smaller outside diameter throughout its length than the inside diameter of the central tube 50 so as to produce the auxiliary inlet flow path 72 therebetween. The inserted pipe 52 and the short pipe 64 of the central tube 50 are welded to each other to secure airtight connection. The inlet tube 7 is covered with an insulating material (not shown).

### The Structure and Operation of the Outlet Tube 8

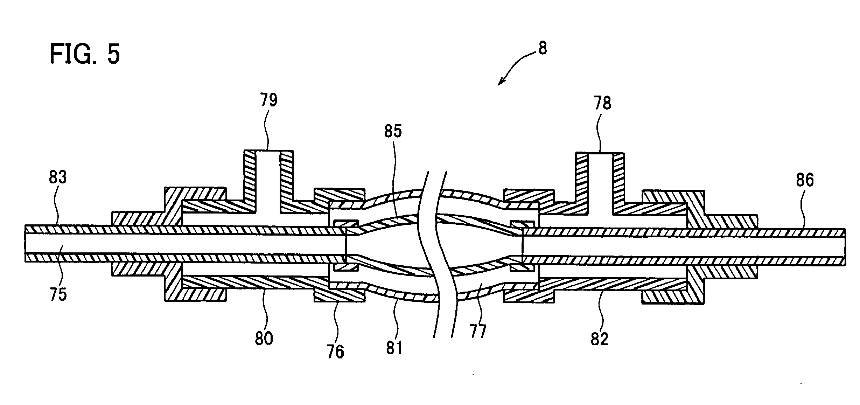

As shown in Fig. 5, the outlet tube 8 has a double construction with a central tube 75 and an outer tube 76. The outer tube 76 consists of a first T-shaped pipe 80, a flexible tube 81, and a second T-shaped pipe 82 connected one after another. The central tube 75 consists of a first short pipe 83, a flexible tube 85, and a second short pipe 86 connected one to another. The central tube 75 and the outer tube 76 are resilient.

The outside diameter of the central tube 75 is smaller than the inside diameter of the outer tube 76 so as to provide an auxiliary outlet flow path 77. The central tube 75 functions as an outlet flow path. The outer tube 76 is provided with an air-inlet 78 and an air-outlet 79.

As described above, the testing section 3 and the agent supplying section 5 communicate with each other by the inlet tubes 7 and the outlet tube 8; that is, each of these tubes 7 and 8 is open within the casing 12 of the testing section 3 and the agent supplying section 5.

The casing 12 is provided with an air-inlet flow path having an air-inlet 18 whose distal end branches off, the branching end having an electromagnetic valve 19. The downstream side of the valve 19 is connected to an air-inlet 78 which is open into the auxiliary outlet flow path 77 of the outlet tube 8.

The air-outlet 79 of the outlet tube 8 is connected to a secondary inlet of the heat-collecting heat exchanger 43 whose secondary outlet is connected to a secondary inlet of the heat exchanger (A) 35. The secondary outlet of the heat exchanger (A) 35 is connected to an air-inlet 56, which means that the secondary outlet of the heat exchanger (A) 35 is connected to the inlet flow path 73.

The air-outlet 57 of the inlet tube 7 is connected to an air-inlet of the cavity 11 of the tray 2 whose air-outlet is connected to one end of the central tube 75 in the outlet tube 8 through a piping 17. More specifically, the air-outlet of the tray 2 is connected to the outlet flow path 8, thereby causing the used air to flow into the outlet tube 8 through the piping 17.

The distal end of the central tube 75 in the outlet tube 8 is connected to a primary inlet of the heat-collecting heat exchanger 43, which is connected to a primary flow path port of the auxiliary heat exchanger (B) 41 whose primary outlet is open in the atmosphere.

A part of the secondary cooling cycle branches off, and the branching parts are respectively connected to the coolant inlet and the coolant outlet 55 of the inlet tube 7. This means that the secondary cold cycle has a bypass 36 to the heat exchanger (A) 35, and the central tube 50 of the inlet tube 7 is connected to the bypass 36.

More specifically, in Fig. 2 the flow path between the expanding valve 33 in the secondary cold cycle and the heat exchanger (A) 35 branches off, and one of the branching flow path is connected to a coolant inlet of the inlet tube 7 whose coolant outlet 55 is connected to a point between the heat exchanger (A) 35 and the second compressor 30. Accordingly, the central tube 50 is brought into parallel with the heat exchanger (A) 35, thereby ensuring that the coolants flowing through the central tube 50 and the heat exchanger (A) 35 has the same temperature.

### The Operation of the Testing Section 3

The testing machine 1 can change a temperature in a range of -65° C to 200° C or higher. Especially, the testing machine 1 is advantageous when it is operated at a low temperature.

More specifically, in order to chill the top surface 10 of the tray 2, the first compressor 20 and the second compressor 30 are both put into operation, and a dry air is introduced from the source of dry air 29 like a compressor. Simultaneously as the two compressors 20 and 30 has started the operation, the cooling cycle starts, thereby causing a cool coolant to flow through the primary side of the heat exchanger (A) 35, and to chill the secondary side thereof.

The coolant flows to the auxiliary inlet flow path 72 through the bypass 36 bypassing the heat exchanger (A) 35. The bypassed coolant is introduced into the central tube 50 from the end of the inserted pipe 52, which is open in the depth of the central tube 50 thereby to enable the coolant to reach the depth thereof.

In this situation, the distal end of the central tube 50 is closed, so that the coolant is caused to flow through the auxiliary inlet flow path 72 and return to the proximal end of the central tube 50. Evidently, the coolant circles throughout the central tube 50, and then it is discharged from the outlet 55.

As described above, the dry air is introduced into the testing section 3 from the source 29. Then, it enters the outlet tube 8 through the air inlet 78 by way of the electromagnetic valve 19, and flows through the auxiliary outlet tube 77 maintained in contact with the outlet tube 8. The air passes through the secondary side of the heat-collecting heat exchanger 43, and then through the secondary side of the heat exchanger (A) 35.

Furthermore, the air enters the air inlet 56 of the inlet tube 7, and flows through the inlet flow path 73 to enter the testing section 3. Then, it enters the cavity 11 of the tray 2 through the piping 16, and from there, it passes through the central tube 75 of the outlet tube 8. In this way, the air flows through the primary side of the heat-collecting heat exchanger 43, and flows through the primary side of the auxiliary heat exchanger (B) 41 to be discharged into the atmosphere.

### Varying Temperatures of the Agent Flowing through Each Section

The agent (air) can have a variety of temperatures at each stage of the flow paths. First, the dry air immediately after having left the source 29 has a room temperature. This air flows through the auxiliary outlet flow path 77, hereinafter called "incoming air", and in the course of flowing it is cooled by another air (called "outgoing air") flowing through the central tube 75 of the outlet tube 8.

As is evident from the above-mentioned description, the outgoing air has a lower temperature than the incoming air, which means that the outgoing air is colder than the room temperature. Thus, the incoming air is robbed of its heat by contact of the outgoing air through the wall of the outlet flow path 75. In this way a cold air is obtained.

The incoming air passes through the auxiliary outlet flow path 77, and then through the secondary side of the heat-collecting heat exchanger 43. The incoming air passing through the outlet piping 8 is cooled by exchanging heat with the outgoing air within the heat-collecting heat exchanger 43.

More specifically, the outgoing flowing through the primary side of the heat-collecting heat exchanger 43 is colder than the incoming air, thereby robbing the incoming air of its heat.

The incoming air passing through the heat-collecting heat exchanger 43 enters the heat exchanger (A) 35 where it is cooled by losing its heat. More specifically, the incoming air flows through the secondary side of the heat exchanger (A) 35 which accepts the flow of a coolant cooled by the cooling device. Thus, the incoming air is cooled in the course of flowing through the heat exchanger (A) 35.

The air passing through the secondary side of the heat exchanger (A) 35 enters the air inlet 56 of the inlet tube 7, and flows through the inlet flow path 73 to enter the testing section 3. During the period of passage the incoming air is cooled by a coolant.

More specifically, the incoming air flows through the inlet flow path 73, and on the other hand, a coolant flows through the auxiliary inlet flow path 72. These flow paths 72 and 73 are located side by side with each other so as to ensure that the coolant continues to take heat from the incoming air, thereby maintaining the incoming air at a low temperature. In contrast, the coolant flowing through the central tube 50 has the same temperature as the coolant flowing through the heat exchanger (A) 35. Thus, the incoming air is liable to little thermal change.

The incoming air enters the cavity 11 of the tray 2 and cools the surface of the tray 2 while it rises up in temperature. The air discharged through the cavity 11 remains colder than the room temperature.

The air discharged through the cavity 11 passes through the outlet flow path 75 of the outlet tube 8 by way of the piping 17, and gives its chillness to the incoming air while it rises up in temperature. The air passing through the central tube 75 of the outlet tube 8 flows through the primary side of the heat-collecting heat exchanger 43, giving its chillness to the incoming air while it rises up in temperature.

The outgoing air flows through the primary side of the auxiliary heat exchanger (B) 41, and contributes to condense the coolant in the first cooling cycle. In this way, this embodiment ensures that heat-taking occurs three times, thereby enhancing thermal efficiency. The final exhaust has substantially the same temperature as the room temperature, thereby providing no thermal change. In the conventional system the air discharged through the cavity of the tray or table was discharged into the atmosphere as it was. Therefore, the outlet was covered with dews. According to the present invention, no such problem occurs due to the fact that the exhaust air is maintained at the room temperature.

The embodiment described above allows a coolant to flow through the central tube 50 of the inlet tube 7, and allows an incoming air to flow through the inlet flow path 73, wherein the coolant is colder than the incoming air (the atmosphere), thereby preventing the coolant from losing its coldness into the atmosphere. The coolant can be caused to reciprocate within the central tube 50, thereby staying therein so much longer and enhancing the heat exchange efficiency.

In addition, the flow path is bent within the central tube 50, so that the fluid flowing therein is liable to a relatively large pressure drag. In contrast, the inlet flow path 73 outside the central tube 50 is straight, so that the fluid therein is liable to less pressure drag. This is the reason why the embodiment allows the incoming air to flow through the inlet flow path 73. However, it is also possible to allow the incoming air through the central tube 50 and the coolant to flow through the inlet flow path.

Likewise, it is possible to allow an outgoing air to flow through the central tube 75 of the outlet tube 8 and an incoming air to flow round it. It is also possible to allow an incoming air to flow through the central tube 75, and an outgoing air to flow round it. The reason is that the incoming air is warmer than the outgoing air.

For illustration's purpose only Figs. 3 and 4 show that the inlet tube 7 is provided with the incoming flow path, the flow paths extending in opposite directions to constitute a double flow path structure, and Fig. 5 shows that the outlet tube 8 is provided with a straight flow path. However, the invention is not limited to this structure, and the outlet tube 8 can be identically constructed as the inlet tube 7, wherein the cavity and around it must be enclosed by a mantle or the like, and also be provided with a pipe which is open in the depth of the cavity so as to effect the introduction and discharge of a coolant or a liquid.

### Another Embodiment of the Invention

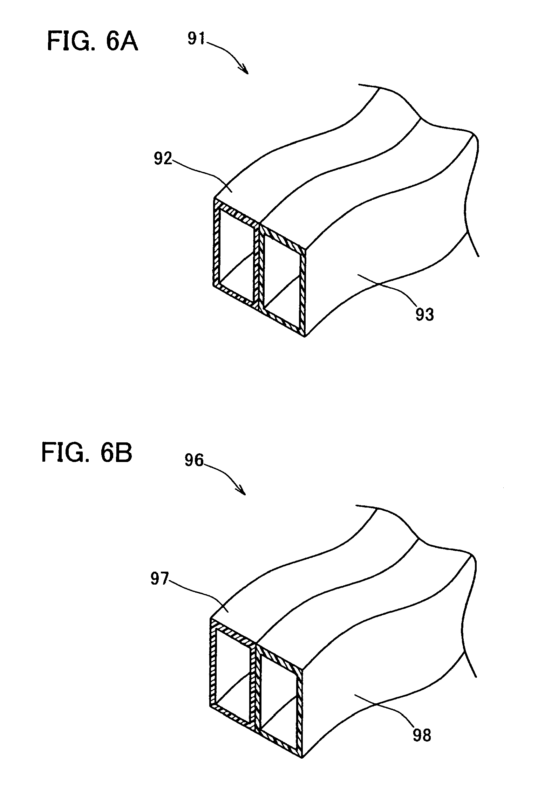

Fig.6 shows another example of the embodiment, characterized by providing a single inlet tube 91 having an inlet tube 92 and an auxiliary inlet tube 93 maintained in contact with each other. Fig. 6(B) shows a modified version of the outlet tube 8; that is, a single outlet tube 96 is provided in which an outlet tube 97 and an auxiliary outlet flow path 98 arranged side by side with each other.

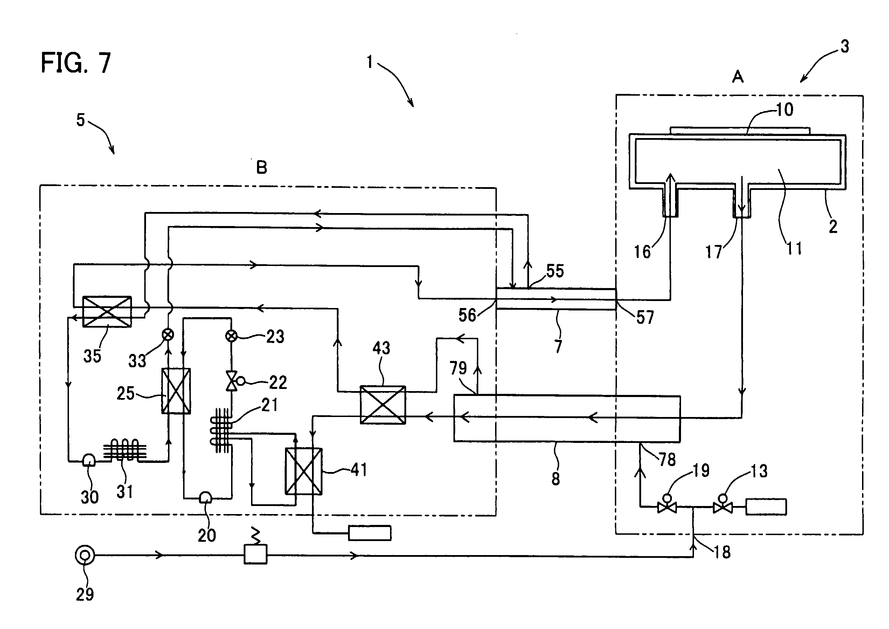

In the embodiment described above, the bypass 36 is connected to the central tube 50 of the inlet tube 7, and bypasses the heat exchanger (A) 35. Another embodiment will be described by referring to Fig. 7:

In Fig. 7, the central tube 50 of the inlet tube 7 is connected in series to the heat exchanger (A) 35. In the arrangement shown in Fig. 7 the central tube 50 of the inlet tube 7 is provided downstream of the expanding valve 33, and the heat exchanger (A) 35 is provided downstream of the central tube 50. However, the heat exchanger (A) 35 can be provided ahead of the central tube 50.

A middle point between the condenser 31 and the expanding valve 33 can branch off, and one branch can be connected to the central tube 50 of the inlet tube 7. This arrangement is advantageous in that the inserted pipe 52 of the central tube 50 can function as a capillary tube.

In this embodiment a cooling device of a two cycle system is employed, and a coolant produced in the second stage of cycle is introduced into the inlet tube 7. However, it is also possible to introduce a coolant produced in the first stage of cycle into the inlet tube 7. In this case, the coolant tends to have a higher temperature than in the first embodiment, and it is necessary to flow a coolant through the outside flow path.

In the two embodiments described above the agent is a thermally adjusted air intended for introduction into the cavity 11 of the tray 2 but it is also possible to use gas such as nitrogen instead of air, and also liquid.

## Claims

1. A system for supplying a thermal agent to a device for testing objects to see how they can withstand thermally hard circumstances, having a testing section for conducting the tests; a thermal agent supplying section, communicating with the testing section by and through an inlet flow path and an outlet flow path; a thermal adjuster accommodated in the testing section so as to produce and maintain a desired temperature therein; **characterized in that** a cooling device operable in a cyclic system, having a heat exchanger (A) for cooling an incoming agent to the testing section through the inlet flow path; and an auxiliary inlet flow path located side by side with the inlet flow path so as to effect heat exchange between a coolant flowing through the auxiliary inlet flow path and an incoming agent through the inlet flow path are provided.

2. A system as defined in claim 1, wherein the primary side of the heat exchanger (A) is used to flow a coolant, and the secondary side is used to flow an incoming agent to the thermal adjuster in the testing section, and further comprising a bypass extending from the primary side of the heat exchanger (A), the bypass communicating with the auxiliary inlet flow path.

3. A system as defined in claim 1, wherein the heat exchanger (A) is connected in series to the auxiliary inlet flow path.

4. A system as defined in one of the preceding claims, wherein the thermal adjuster of the testing section comprises a main outlet flow path and an auxiliary outlet flow path arranged side by side with each other so as to allow an incoming agent from the atmosphere or an outgoing agent from the thermal adjuster to enter the auxiliary outlet flow path, and then flow through the heat exchanger (A).

5. A system as defined in claim 4, further comprising a heat-collecting heat exchanger for effecting heat exchange between an outgoing agent through the outlet flow path and an incoming agent from the atmosphere, thereby taking its coldness from the outgoing agent.

6. A system as defined in claim 4 or 5, further comprising a compressor included in the cooling device, and an auxiliary heat exchanger (B) for effecting heat exchange between an agent outgoing through the outlet flow path and a coolant having left the compressor.

7. A system as defined in one of the preceding claims, wherein each of the combination of the inlet flow path and the auxiliary inlet flow path, and the combination of the outlet flow path and the auxiliary outlet flow path has a multi-layer structure of a central tube and an outer tube covering at least part of the central tube.

8. A system as defined in one of claims 1-6, wherein one of the combination of the inlet flow path and the auxiliary inlet flow path, and the combination of the outlet flow path and the auxiliary outlet flow path has a multi-layer structure of a central tube and an outer tube covering at least part of the central tube.

9. A system as defined in claim 7 or 8, wherein the central tube comprises an inserted pipe through which an agent is allowed to flow in and out, the inserted pipe being open in the depth of the central tube.

10. A system as defined in claim 9, wherein the central tube comprises a port located near its distal end through which an agent or a coolant is entered or discharged, and the inserted pipe is inserted near the port.

11. A system as defined in one of the preceding claims, wherein the agent is gaseous, and the thermal adjuster comprises a cavity for receiving the gaseous agent.

12. A system as defined in one of the preceding claims, wherein the outgoing agent from the thermal adjuster of the testing section is used as a coolant for the incoming agent.
